(19) Europäisches Patentamt
European Patent Office
Office européen des brevets

(11) **EP 1 470 441 B1**

(12) **EUROPÄISCHE PATENTSCHRIFT**

(45) Veröffentlichungstag und Bekanntmachung des Hinweises auf die Patenterteilung:
**12.07.2006 Patentblatt 2006/28**

(21) Anmeldenummer: **03734709.3**

(22) Anmeldetag: **29.01.2003**

(51) Int Cl.:
*G02B 6/12* (2006.01)        *C30B 33/00* (2006.01)
*C30B 29/60* (2006.01)

(86) Internationale Anmeldenummer:
**PCT/EP2003/000861**

(87) Internationale Veröffentlichungsnummer:
**WO 2003/065094 (07.08.2003 Gazette 2003/32)**

(54) **PHOTONISCHE KRISTALLE MIT SKELETTSTRUKTUR**

PHOTONIC CRYSTALS HAVING A SKELETON STRUCTURE

CRISTAUX PHOTONIQUES A STRUCTURE POSSEDANT UN SQUELETTE

(84) Benannte Vertragsstaaten:
**AT BE BG CH CY CZ DE DK EE ES FI FR GB GR HU IE IT LI LU MC NL PT SE SI SK TR**

(30) Priorität: **01.02.2002 DE 10204318**

(43) Veröffentlichungstag der Anmeldung:
**27.10.2004 Patentblatt 2004/44**

(73) Patentinhaber: **Studiengesellschaft Kohle mbH**
**45470 Mülheim (DE)**

(72) Erfinder:
• **MARLOW, Frank**
  **10178 Berlin (DE)**
• **DONG, Wenting**
  **Shanghai 200093 (CN)**

(56) Entgegenhaltungen:
**EP-A- 1 089 095**

• YABLONOVITCH E ET AL: "3-DIMENSIONAL PHOTONIC BAND STRUCTURE" OPTICAL AND QUANTUM ELECTRONICS, CHAPMAN AND HALL, LONDON, GB, Bd. 24, Nr. 2, 1. April 1992 (1992-04-01), Seiten S273-S283, XP000372052 ISSN: 0306-8919
• NOTOMI M ET AL: "DRILLED ALTERNATING-LAYER THREE-DIMENSIONAL PHOTONIC CRYSTALS HAVING A FULL PHOTONIC BAND GAP" APPLIED PHYSICS LETTERS, AMERICAN INSTITUTE OF PHYSICS. NEW YORK, US, Bd. 77, Nr. 26, 25. Dezember 2000 (2000-12-25), Seiten 4256-4258, XP000994358 ISSN: 0003-6951
• SUBRAMANIAN G ET AL: "ORDERED MACROPOROUS MATERIALS BY COLLOIDAL ASSEMBLY: A POSSIBLE ROUTE TO PHOTONIC BANDGAP MATERIAL" ADVANCED MATERIALS, VCH VERLAGSGESELLSCHAFT, WEINHEIM, DE, Bd. 11, Nr. 15, 20. Oktober 1999 (1999-10-20), Seiten 1261-1265, XP000869415 ISSN: 0935-9648
• LANATA M ET AL: "Titania inverse opals for infrared optical applications" OPTICAL MATERIALS, ELSEVIER SCIENCE PUBLISHERS B.V. AMSTERDAM, NL, Bd. 17, Nr. 1-2, Juni 2001 (2001-06), Seiten 11-14, XP004254781 ISSN: 0925-3467
• RICHEL A ET AL: "OBSERVATION OF BRAGG REFLECTION IN PHOTONIC CRYSTALS SYNTHESIZED FROM AIR SPHERES IN A TITANIA MATRIX" APPLIED PHYSICS LETTERS, AMERICAN INSTITUTE OF PHYSICS. NEW YORK, US, Bd. 76, Nr. 14, 3. April 2000 (2000-04-03), Seiten 1816-1818, XP000950572 ISSN: 0003-6951
• KAWAKAMI S ET AL: "FABRICATION OF 3D PHOTONIC CRYSTALS BY AUTOCLONING ITS APPLICATIONS" ELECTRONICS & COMMUNICATIONS IN JAPAN, PART II - ELECTRONICS, SCRIPTA TECHNICA. NEW YORK, US, Bd. 82, Nr. 9, PART 2, September 1999 (1999-09), Seiten 43-52, XP000923884 ISSN: 8756-663X

**Beschreibung**

Die Erfindung betrifft eine Klasse von photonischen Kristallen, die den bekannten inversen Opalen ähneln, aber bisher nicht bekannte Bandlücken oder größere Pseudobandlücken, insbesondere zwischen dem 5, und 6. Band und/oder zwischen dem 8. und 9. Band aufweisen. Des weiteren betrifft die Erfindung ein Verfahren zur Herstellung von photonischen Kristallen und deren Verwendung als Laserresonator, Matrix für Lichtwellenleiter, opaleszentes Pigment, Strahlenteiler, spektralen Filter oder als Bestandteil solcher Vorrichtungen.

**Hintergrund der Erfindung**

Photonische Kristalle sind Materialien, in denen der Brechungsindex räumlich periodisch variiert, wobei Gitterkonstanten im Bereich der Lichtwellenlänge von besonderem Interesse sind. Den sich in diesen Medien ausbreitenden Lichtwellen wird die periodische Variation des Materials aufgeprägt (siehe z. B. J. D. Joannopoulos, R. D. Meade, J. N. Winn, *Photonic Crystals: Molding the flow of light.* Princeton University Press, 1995). Es zeigt sich, dass es diese periodisch modulierten Wellen für eine ausgewählte Richtung nicht für jede Frequenz geben kann. Insbesondere wenn die Wellenlänge dieser Wellen nahezu mit den Netzebenenabständen des photonischen Kristalls übereinstimmt, wird die Ausbreitung durch Vielfachstreuung stark modifiziert und ihre Frequenz abgesenkt oder angehoben. Dadurch entstehen Lücken auf der Frequenzskala, in denen keine mathematische Lösung für das Ausbreitungsproblem von elektromagnetischen Wellen in dem periodischen Material existiert. Je nach dem, ob diese Lücken für alle Richtungen von elektromagnetischen Wellen oder nur in einem eingeschränkten Bereich von Richtungen auftreten, bezeichnet man diese Frequenzlücken als Bandlücken oder als Pseudobandlücken. Ihre Berechnung erfordert die Behandlung der Wellengleichung für das elektromagnetische Feld, wofür Methoden entwickelt wurden, die ähnlich bei der Schrödinger-Gleichung in einem periodischen Potential verwendet werden (J. D. Joannopoulos, R. D. Meade, J. N. Winn, Photonic Crystals: Molding the flow of light. Princeton University Press, 1995; K. Busch, S. John, Phys. Rev. E 58 (1998) 3896; S. G. Johnson, J. D. Joannopoulos, Optics Express 8 (2000) 173).

Photonische Kristalle sind von hohem Interesse für die Anwendung in optischen Bauelementen, wie sie beispielsweise in der Kommunikationsindustrie verwendet werden. Insbesondere Materialien mit großen optischen Bandlücken ermöglichen neuartige optische Funktionalitäten (F. Marlow, *Nachrichten Chem.* 49 (2001) 1018).

Die Herstellung photonischer Kristalle kann ausgehend von Kugelpackungen erfolgen. Jedoch hat eine dichte Packung von Kugeln mit hohem Brechungsindex nie eine vollständige Bandlücke, wohl aber ihre inverse Struktur, dicht angeordnete kugelförmige Hohlräume in einem Material mit hohem Brechungsindex. Daraus wurde eine Herstellungsmethode abgeleitet, bei der eine ursprüngliche Kugelpackung als Formkörper (Negativform) für die inverse Struktur benutzt wird, die im folgenden als Restvolumenstruktur (RVS) bezeichnet werden soll, wenn sie den Formkörper vollständig ausfüllt (Y. A. Vlasov, N. Yao, D. J. Norris, Adv. Mater. 11 (1999) 165; A. Zakhidov et al. U.S. Patent 6,261,469). Außerdem wurden Herstellungsverfahren für Schalenstrukturen gefunden, bei denen der Formkörper durch eine Schicht eines Materials belegt wird (J.E. Wijnhoven, W.L. Vos, *Science,* 281 (1998) 802).

Restvolumenstrukturen sind überwiegend konkav, da sie sich von einer konvexen Form (Kugelpackung) ableiten. Diese Eigenschaft kann durch den mittleren Krümmungsradius *<R>* einer Struktur mit der Gesamtoberfläche *A* wie folgt beschrieben werden:

$$\langle R \rangle = \frac{1}{A} \iint\limits_A dA\, \overline{R}(x)$$

$$2/\overline{R}(x) = 1/R_1 + 1/R_2$$

Dabei sind $R_1$ und $R_2$ die zwei extremen Krümmungsradien der Oberfläche im Punkt x. Sie sollen definitionsgemäß positiv sein, falls das Zentrum des Krümmungskreises im dichten Material liegt. Damit hat beispielsweise ein Polystyren-Opal aus Kugeln des Radius $R_{ps}$ einen mittleren Krümmungsradius von $<R> = R_{ps}$ (d.h. einen positiven $<R>$) und eine dementsprechende ideale RVS (inverser Opal) einen negativen $<R>$ von $<R> = -R_{ps}$. Strukturen mit positiven $<R>$ werden als überwiegend konvex, solche mit negativen $<R>$ als überwiegend konkav bezeichnet.

Überwiegend konkave Strukturen sind jedoch mit einer Reihe von Problemen behaftet, da derartige Strukturen in der Regel scharfe Kanten (d.h. relativ kleine Regionen mit extrem kleinem positivem Krümmungsradius) aufweisen. Diese Kanten verbinden die konkaven Teilflächen. An diesen Kanten ist das Verhalten der elektromagnetischen Felder äußerst kompliziert. Das äußert sich in Berechnungsschwierigkeiten (Konvergenzprobleme) und in einer starken Abhängigkeit von der genauen Kantenform, was die zielgerichteten Steuerungsmöglichkeiten für die optischen Eigenschaften einschränkt. Weiterhin sind die Realisierungsmöglichkeiten für derartige Strukturen eingeschränkt, da sie in der Regel vollständige Porenfüllungen (im ursprünglichen Opal) sowie eine sehr präzise Kontrolle der genauen Kantenform erfordern.

**Figurenbeschreibung**

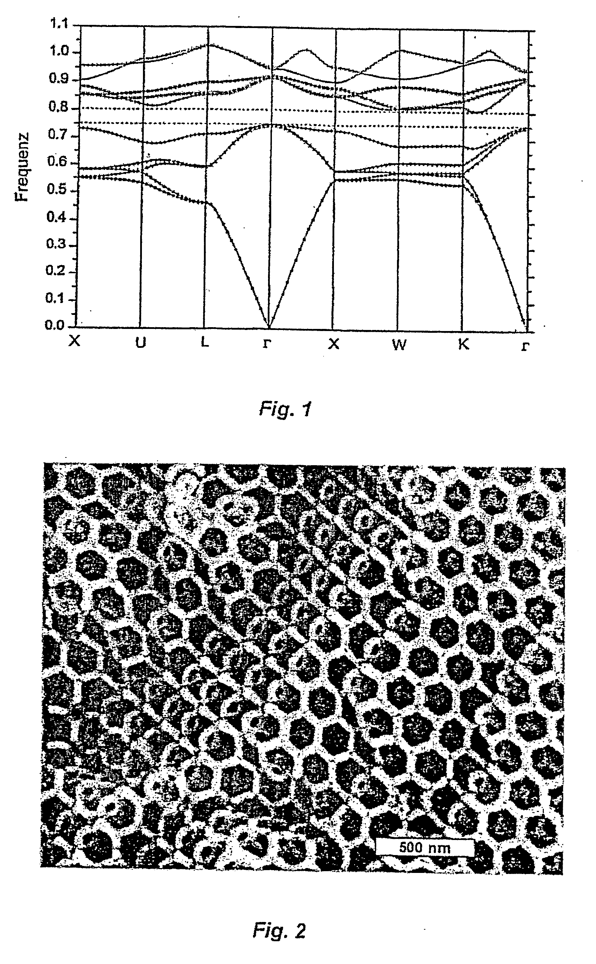

*Fig. 1*: Bandstruktur für ein Modellsystem aus Zylindern, die die Mittelpunkte der oktaedrischen und tetraedrischen Hohlräume einer hexagonal dichten Kugelpackung (mit fcc-Gitter) miteinander verbinden. Die Frequenz ist in der Einheit *c/a* angegeben, wobei c die Vakuumlichtgeschwindigkeit und a die Kantenlänge der gebräuchlichen kubischen Einheitszelle (mit 4-fachem Volumen der primitiven Zelle) des fcc-Gitters bedeuten. Der Wellenvektor *k* variiert innerhalb der Brillouinzone von X über U, L, Γ, X, W, K zurück zu Γ. Im Vergleich zu Standarddarstellungen wie z.B. in J.D. Joannopoulos, R.D. Meade, J.N. Winn in *Photonic Crystals: Molding the flow of light,* Princeton University Press, 1995, S. 80, wurde die Verbindung zwischen K- und Γ-Punkt zusätzlich betrachtet.

*Fig. 2:* Rasterelektronenmikroskopische Aufnahme (Beschleunigungsspannung 25 KV, 40.000fache elektronenmikroskopische Vergrößerung) einer Skelettstruktur. Die Verbindungsstücke sind zylinderförmig und weisen einen Zylinderradius von ca. 0,06 a auf.

## Beschreibung der Erfindung

Der Erfindung liegt die Aufgabe zugrunde, photonische Kristalle mit vorwiegend konvexen Strukturen sowie ein Verfahren zu deren Herstellung zur Verfügung zu Stellen, welches ausgehend von Opalstrukturen die Variation der Strukturparameter, insbesondere der Zylinderdicke, erlaubt und welches die reproduzierbare Synthese von photonischen Kristallen mit einem breiteren Anwendungsbereich ermöglicht.

Ein erster Aspekt der Erfindung betrifft einen photonischen Kristall, dessen Struktur topologisch äquivalent zur inversen Struktur eines überwiegend konvexen Formkörpers ist, dadurch gekennzeichnet, dass dieser

- eine vorwiegend konvexe Struktur besitzt und

- eine Bandlücke oder Pseudobandlücke zwischen dem 5, und 6. Band und/oder

- eine Bandlücke oder Pseudobandlücke zwischen dem 8. und 9. Band aufweist,

wobei wenigstens eine Bandlücke oder Pseudobandlücke größer ist als die der, aus dem gleichen Material wie der photonische Kristall bestehenden, inversen Struktur des überwiegend konvexen Formkörpers.

Ein zweiter Aspekt der Erfindung betrifft ein Verfahren zur Herstellung eines photonischen Kristalls, ausgehend von einem überwiegend konvexen Formkörper, umfassend die Schritte

(A) Penetration eines Matrixprecursors in die Hohlräume des konvexen Formkörpers;

(B) Umwandlung des Matrixprecursors zum Matrixbildner;

(C) Umverteilung des in den Hohlräumen befindlichen Matrixprecursors/ Matrixbildners und/oder deren Zwischenstufen unter Erhalt der Topologie;

(D) Entfernen des Formkörpers.

Ein dritter Aspekt der Erfindung betrifft einen Photonischen Kristall, erhältlich durch das zuvor beschriebene Verfahren

Ein vierter Aspekt der Erfindung betrifft die Verwendung des erfindungsgemäßen photonischen Kristalls als Laserresonator, Matrix für Lichtwellenleiter, opaleszentes Pigment, Strahlenteiler oder spektralen Filter oder als Bestanteil der zuvor genannten Vorrichtungen.

Bevorzugte Ausgestaltungen der Erfindung ergeben sich aus den Unteransprüchen.

Die erfindungsgemäßen photonischen Kristalle sollen als Skelettstrukturen bezeichnet werden, da sie aus zylinderartigen oder deformierten Zylindern ähnlichen Einzelteilen zusammengesetzt werden können. Diese Einzelteile sind konvexe Gebilde, die nur durch kleine konkave Übergangsstücke zusammengehalten werden.

Für die Herstellung der erfindungsgemäßen Strukturen ist es bedeutsam, dass sich eine unvollständige Füllung des Formkörpers bandlückenvergrößernd auswirkt. Außerdem können bei geeigneten Herstellungsverfahren Teile dieser Strukturen mit dem Formkörper mathematisch überlappen, wenn die letzte Phase der Herstellung der Skelettstrukturen simultan mit der Entfernung des Formkörpers erfolgt.

Die zugrundeliegenden überwiegend konvexen Formkörper, die als "Negativform" für die erfindungsgemäßen photonischen Strukturen dienen, weisen eine Opalstruktur auf. Die Formkörper sind nach den im Stand der Technik bekannten Verfahren zur Erzeugung von Opalen z.B. Sedimentation, ausgehen von einer Vielzahl von Materialien erhältlich. Entscheidend ist, dass die verwendeten Materialien zu entsprechend kleinen Kugeln geformt werden können. Insbesondere haben sich Polymere und amorphe anorganische Oxide als geeignet erwiesen, die ausgewählt sind aus der Gruppe bestehend aus Polystyrol, Polymethylmethacrylat (PMMA), Polydivinylbenzol, Poly(styrol-co-divinylbenzol), Melaminharze und Siliziumdioxid. '

Bevorzugte Stoffe, welche die erfindungsgemäßen Strukturen bilden (infolge als Matrixbildner bezeichnet) sind Oxide, Halbleiter, Metalle und Polymere, die in Form von Matrixprecursoren, vorzugsweise in Lösung zur Verfügung gestellt werden. Geeignete Matrixprecursoren umfassen wenigstens eine Verbindung, die ausgewählt ist aus der Gruppe, bestehend aus

(i) Metallalkoxiden der allgemeinen Formel $M^{n+}$

(OR)$_n$, wobei R eine verzweigte oder unverzweigte Kohlenwasserstoffgruppe mit 1 bis 12, vorzugsweise 2 bis 8, besonders bevorzugt 3 bis 4 Kohlenstoffatomen ist und M ein Metall ist, welches ausgewählt ist aus den Gruppen IIb, IIIa, IIIb, IVa, IVb und VIIIb des Periodensystems der Elemente;

(ii) Metallhalogeniden oder -nitraten der allgemeinen Formel $M^{n+}(X^-)_n$, wobei X ein Halogenid-Ion, ausgewählt aus F, Cl$^-$, Br$^-$ und I$^-$ oder ein Nitrat-Ion (NO$_3^-$) ist und M ein Metall ist, welches ausgewählt ist aus den Gruppen IIb, IIIa, IIIb, IVa, IVb und VIIIb des Periodensystems der Elemente.

Beispiele solcher Verbindungen sind Titanisopropoxid, Aluminiumchlorid, Aluminiumnitrat, Eisen(III)chlorid und Eisen(III)nitrat.

Als Lösungsmittel oder Zusätze für die zuvor genannten Verbindungen eignen sich vorzugsweise Alkohole oder deren Gemische, die ausgewählt sind aus der Gruppe bestehend aus Methanol, Ethanol, 1- oder 2-Propanol und 1-, 2- oder *tert*-Butanol. Die Verwendung von Wasser als Lösungsmittel oder Zusatz, entweder allein oder im Gemisch mit den zuvor genannten Lösungsmitteln kann günstig sein. Bei flüssigen Precursoren kann auf die Verwendung eines Lösungsmittels oder Zusatzes oftmals völlig verzichtet werden. Vom Lösungsmittel bzw. Zusatz sind die Fließeigenschaften des Precursors und die resultierenden Strukturparameter abhängig.

Die Umwandlung der Matrixprecursoren zu den Matrixbildnern erfolgt nach ihrer Penetration in die Hohlräume des Formkörpers durch Kalzinierung, Kondensation, Hydrolyse, Oxidation, Reduktion oder Trocknung oder Kombinationen der zuvor genannten Reaktionen.

Die genauen Reaktionsbedingungen die zur Umwandlung der Matrixprecursoren zu den Matrixbildnern erforderlich sind, sind von der Natur der gewählten Matrixprecursoren abhängig. So kann beispielsweise die Verwendung von Metallalkoxiden als Precursoren, zur Umwandlung durch Hydrolyse und Kondensation den Kontakt mit der Luftfeuchtigkeit erfordern.

In allen Fällen ist jedoch entscheidend, dass die Hohlräume des Formkörpers, durch Schrumpfung der Matrixprecursoren/-bildner, die während der Umwandlung vom Matrixprecursor zum Matrixbildner erfolgt, nicht vollständig ausgefüllt werden.

Eben diese Schrumpfung ermöglicht eine gezielte Umverteilung der Matrixprecursoren/-bildner in definierte Volumensegmente der Hohlräume des Formkörpers unter Ausbildung der gewünschten Skelettstruktur.

Entscheidend für den realisierbaren Bereich von Strukturparametern ist in vielen Fällen, dass die Umverteilung des Matrixprecursors (C) und die Entfernung des Formkörpers (D) simultan erfolgen.

Dabei werden vorzugsweise gelartige Zwischenstufen der inversen Struktur in den Poren des Opals genutzt, die während der Umwandlung der Matrixprecursoren zu den Matrixbildnern z.B. durch Kondensation auftreten.

Insbesondere bei der Nutzung solcher gelartigen Zwischenstufen können die Schritte (B) und (C) simultan erfolgen.

Eine andere Möglichkeit ist die Nutzung von anderen bekannten Herstellungsprozessen für inverse Opale (z.B. A. Zakhidov et al., U.S. Patent 6,261,469), wobei zunächst ein inverser Opal geringerer Dichte hergestellt wird, der dann einem nachfolgenden Schrumpfoder Temperprozess unterworfen wird, der die Form der einzelnen Strukturelemente verändert, die Topologie der Struktur aber erhält. Auch die Anwendung von Ätzprozessen ist eine Möglichkeit der nachträglichen Formung des inversen Opals.

Die Entfernung des Formkörpers (C) aus der Skelettstruktur kann durch kalzinieren, ätzen oder auflösen erfolgen.

Die Kalzinierung erfolgt, in Abhängigkeit von den jeweiligen Formkörper und Matrixprecursoren/-bildnern, bei Temperaturen von 450 bis 700 °C, vorzugsweise 500 bis 650 °C, besonders bevorzugt 550 bis 600 °C innerhalb eines Zeitintervalls von 2 bis 12 h, vorzugsweise 4 bis 10 h, besonders bevorzugt 5 bis 8 h. Es hat sich dabei als vorteilhaft erwiesen, der eigentlichen Kalzinierung eine Aufheizphase mit einer Aufheizrate von 0,8 bis 10 °C/min, vorzugsweise 2 bis 8 °C/min, besonders bevorzugt 5 bis 6 °C vorzuschalten und die Abkühlung mit einer Abkühlrate von 1 bis 15 °C/min, vorzugsweise 4 bis 12 °C/min, besonders bevorzugt 8 bis 10 °C/min durchzuführen. Die Kalzinierung kann in einer Vielzahl von unterschiedlichen Öfen durchgeführt werden. Geeignete Öfen sind durch den Stand der Technik beschrieben und dem Fachmann hinlänglich bekannt.

Die Entfernung der Formkörper durch Ätzen oder Lösen wird vorzugsweise dann durchgeführt, wenn Formkörper, umfassend Materialien von hoher thermischer Stabilität, verwendet wurden. Beispielsweise kann ein Formkörper aus SiO$_2$, der aufgrund seiner hohen thermischen Stabilität durch Kalzinieren nicht zu entfernen ist, mit Hilfe von Flusssäure (HF) aus der Skelettstruktur entfernt werden. Voraussetzung dafür ist jedoch, dass die Matrixbildner nicht durch Flusssäure angegriffen werden.

Die durch das erfindungsgemäße Verfahren erhältlichen photonischen Kristalle sind dadurch gekennzeichnet, dass diese

- eine vorwiegend konvexe Struktur besitzten und

- eine Bandlücke oder Pseudobandlücke zwischen dem 5. und 6. Band und/oder

- eine Bandlücke oder Pseudobandlücke zwischen dem 8. und 9. Band auf weisen.

Die erfindungsgemäßen photonischen Kristalle ähneln zwar in ihrer chemischen Zusammensetzung den bekannten RVS oder Schalenstrukturen, besitzen jedoch eine deutlich andere räumliche Form.

Die erfindungsgemäßen Kristalle, die durch vorzugsweise unvollständige Füllung der Hohlräume eines überwiegend konvexen Formkörpers (z. B. einer Kugelanordnung) entstehen, weisen wenigstens eine vollständige Bandlücke oder eine Pseudobandlücke auf. Eine Bandlücke/Pseudobandlücke ist dabei größer als die Bandlücke oder Pseudobandlücke der aus dem gleichen Material wie der photonische Kristall bestehenden inversen Struktur des überwiegend konvexen Formkörpers.

In einer weiteren erfindungsgemäßen Ausführungsform besitzen die photonischen Kristalle mehrere Bandlücken gleichzeitig.

Der Nachweis der Bandlücken erfolgte mittels Modellrechnungen. Die Rechnungen wurden mit Hilfe der MIT Photonic-Bands (MPB) Software (erhältlich als Freeware unter http://ab-initio.mit.edu/mpb) durchgeführt, welche im Stand der Technik (S.G. Johnson und J.D. Joannopoulos in *Optics Express* 8 (2000) 173) bekannt ist. Typischerweise wurden 10 Bänder mit den Parametern grid-size (16 16 16), mesh-size 7 und tolerance $10^{-7}$ berechnet.

Topologisch sind die Skelettstrukturen der erfindungsgemäßen photonischen Kristalle den bekannten inversen Strukturen von Opalen oder gesinterten Opalen gleich ("topologisch äquivalent"), falls es sich dabei um RVS oder Variationen davon (z. B. mit abgerundeten Kanten) handelt. Demzufolge ist (a) der Gittertyp gleich, (b) die Existenz von Verbindungen (Fenstern) zwischen Hohlräumen unterscheidet sich nicht und (c) die Existenz von Verbindungen zwischen den Gerüstkreuzungen ist unverändert. Unterschiede der Skelettstrukturen und der RVS liegen vor allem in der Form der Verbindungen zwischen den Gerüstkreuzungen (kreisförmiger oder kreisähnlicher Querschnitt bei den Skelettstrukturen) und in der Form der Gerüstkreuzungen.

Als Gerüstkreuzungen werden Ansammlungen von dichtem Material (Matrixbildner) in den größten Hohlräumen des Formkörpers, beispielsweise in den oktaedrischen, tetraedrischen und gegebenenfalls anderen Zwischenräumen in formgebenden Kugelpackungen, bezeichnet. Diese Zwischenräume müssen mindestens von 4 Kugeln gebildet werden.

Hohlräume in den Skelettstrukturen sollen hier vorzugsweise mit Luft gefüllte Hohlräume bedeuten, sie können aber auch mit einem Material von geringem Brechungsindex (geringer als der des Gerüstes) gefüllt sein.

Das Gerüst ist die Gesamtheit der Ansammlungen mit dichtem Material (Matrixbildner).

Modellrechnungen an Skelettstrukturen zeigen, dass anstatt bzw. neben der bekannten Bandlücke zwischen dem 8. und 9. Band eine Bandlücke zwischen dem 5. und 6. Band auftritt ("5-6-Materialien" bzw. "5-6/8-9-Materialien"). Dabei wurden Skelettstrukturen verwendet, die aus Zylindern bestehen und die Mittelpunkte der oktaedrischen und tetraedrischen Hohlräume eines Opals mit fcc-Struktur (kubisch flächenzentriertes Gitter) miteinander verbinden. Die Bandlücke zwischen dem 5. und 6. Band tritt oberhalb eines Brechungsindexkontrastes $n$ (Verhältnis des Brechungsindex des Gerüsts zum Brechungsindex der Hohlräume) von 2,9 in optimierten Strukturen auf (siehe Fig. 1). Sie ist durch ein Maximum des 5. Bandes im Gamma-Punkt und durch ein Minimum des 6. Bandes innerhalb der Brillouinzone bei zirka $k = 0,82\ k(K)$ gekennzeichnet, wenn beispielsweise eine Skelettstruktur aus Zylindern mit optimiertem Radius verwendet wird. Dabei ist $k(K)$ der Quasiimpuls am K-Punkt der Brillouinzone (zur Definition des K- und Gammapunktes siehe O. Madelung, Festkörpertheorie, Springer Berlin, 1972, S. 87). Diese Bandlücke wurde bisher weder für eine RVS noch für eine Schalenstruktur vorhergesagt oder gefunden.

In den aus Zylindern bestehenden Skelettstrukturen des fcc-Gitters treten außerdem simultan mehrere Bandlücken unterhalb des 10. Bandes (d.h. bei relativ niedrigen Frequenzen) auf. Simultan zur Bandlücke zwischen dem 5. und 6. Band öffnet sich die Bandlücke zwischen dem 8. und 9. Band für eine Struktur mit einem Zylinderradius von $r_{zy} = 0,0986\ a$ oberhalb von ca. $n = 3,15$. Dabei ist $a$ die Kantenlänge der gebräuchlichen kartesischen Einheitszelle des fcc-Gitters, bei der die primitiven Einheitsvektoren des fcc-Gitters mit den halben Flächendiagonalen zusammenfallen (siehe z.B. Ch. Kittel, Einführung in die Festkörperphysik, Oldenbourg Verlag, München 1999, S. 14).

Des weiteren wurde eine Vergrößerung der Bandlücke zwischen dem 8. und 9. Band gefunden, wenn Teile einer Skelettstruktur zu einer RVS hinzugefügt werden und dabei Teile der RVS ersetzen. Für den Brechungsindexkontrast $n = 3,4$ kann dadurch beispielsweise eine Bandlücke von 6,7 % der Mittelfrequenz der Bandlücke erreicht werden.

Diese Eigenschaften eröffnen neue Anwendungsperspektiven als "photonic bandgap materials" für optische Schaltkreise und opaleszente Pigmente. Beispielsweise können Laser mit geringer Schwellenenergie, Lichtleiterverbindungen mit extrem kleinen möglichen Krümmungsradien, optische Strahlteiler und Bauelemente zur spektralen Filterung auf Basis dieser photonischen Kristalle hergestellt oder verbessert hergestellt werden, wobei die großen und leichter realisierbaren Bandlücken eingesetzt werden. Die simultan auftretenden Bandlücken können für die simultane Behandlung verschiedener Frequenzbereiche, wie z.B. zweier Telekommunikationsfenster, in den genannten Bauelementen genutzt werden. Außerdem ermöglichen sie Laser oder ähnliche Bauelemente, in denen zwei lumineszierende Spezies verwendet werden und deren Lumineszenz jeweils durch eine unterschiedliche Bandlücke unterdrückt wird.

Die vorliegende Erfindung soll anhand des folgenden Beispiels näher erläutert werden, ohne sie jedoch auf dieses zu beschränken.

**Beispiel**

Ein inverser $TiO_2$-Opal wurde mit Hilfe eines Polystyren-Opals (PS-Opal) hergestellt. Dazu wurden alle Chemikalien in der vom Hersteller gelieferten Reinheit verwendet. Als erster Schritt wurde ein PS-Opal aus einer verdünnten Suspension von PS-Teilchen (Firma Microparticles, Durchmesser: 270 nm, Konzentration 1 Gew.-%) durch langsames Eintrocknen bei Raumtemperatur (ca. 2 Wochen in abgedeckter Petrischale) hergestellt. Dann wurden Stücke des PS-Opals von ca. 1 - 3 $mm^3$ einer Precursorlösung für 10 min bis zu 15 Tagen ausgesetzt, was zur Infiltration der Precursorlösung führte. Die Precursorlösung bestand typischerweise aus 80 Vol..-% Titanisopropoxid ($Ti(O-i-C_3H_7)_4$, Firma Merck) und 20 Vol.-% Ethanol (Firma-Merck). Nach der Infiltration wurden die gesättigten Opalstücke der Umgebungsluft für wenigstens 1 Stunde (typischerweise einige Tage) ausgesetzt, um eine Reaktion mit der Luftfeuchtigkeit zu erlauben. Das entstehende Kompositmaterial wurde abschließend bei 450 - 700°C in Luft kalziniert.

Bei den gewählten Trocknungsbedingungen (nach der Precursorinfiltration) zeigen die entstehenden Proben eine Schichtstruktur bei den 1-3 $mm^3$ großen Probenstücken. In rasterelektronenmikroskopischen Untersuchungen (Beschleunigungsspannung 25 KV, 40.000fache elektronenmikroskopische Vergrößerung) der Probenstücke wurde außen fast immer eine etwa 1-5 $\mu$m dicke Haut aus $TiO_2$ ohne reguläre Strukturen im Größenbereich größer 10 nm beobachtet, die vereinzelte Poren enthalten kann. Dem schließt sich eine Übergangsschicht einer Dicke zwischen 1 $\mu$m und 50 $\mu$m an, in der inverse Opalstrukturen unterschiedlicher Konstruktion (RVS, Schalenstrukturen und Skelette) auftreten. Dabei werden vor allem fcc-Gitter beobachtet. Der Kern der Probenteilchen besteht jedoch fast vollständig aus einer Skelettstruktur (Siehe Fig. 2). Dabei sind die Verbindungen zwischen den Gerüstkreuzungen nahezu zylinderförmig, aus diesen Verbindungen gebildete Fenster polygonartig (Viereck-, Fünfeck- oder Sechseckähnlich) und die Gerüstkreuzungen kaum verdickt im Vergleich zu den zylinderförmigen Verbindungen. Es wurden Zylinderradien zwischen 0,04 $a$ und 0,12 $a$ erhalten. Das entspricht positiven mittleren Krümmungsradien zwischen 0,08 $a$ und 0,24 $a$. Die Kantenlänge $a$ der gebräuchlichen Einheitszelle lag zwischen 250 und 360 nm. Anhand von Modellrechnungen konnten für die Strukturen Pseudobandblücken zwischen dem 5. und 6. Band nachgewiesen werden, die größer als in der topologisch äquivalenten RVS sind. Die Rechnungen wurden mit Hilfe der MIT Photonic-Bands (MPB) Software (erhältlich unter http://ab-initio.mit.edu/mpb) durchgeführt, welche im Stand der Technik (S.G. Johnson und J.D. Joannopoulos in *Optics Express* 8 (2000) 173) bekannt ist. Typischerweise wurden 10 Bänder mit den Parametern grid-size (16 16 16), mesh-size 7 und tolerance $10^{-7}$ berechnet.

**Patentansprüche**

1. **Photonischer Kristall,** dessen Struktur topologisch äquivalent zur inversen Struktur eines überwiegend konvexen Formkörpers ist, **dadurch gekennzeichnet, dass** dieser

   - eine vorwiegend konvexe Struktur besitzt und
   - eine Bandlücke oder Pseudobandlücke zwischen dem 5. und 6. Band und/oder
   - eine Bandlücke oder Pseudobandlücke zwischen dem 8. und 9. Band aufweist,

   wobei wenigstens eine Bandlücke oder Pseudobandlücke größer ist als die der, aus dem gleichen Material wie der photonische Kristall bestehenden, inversen Struktur des überwiegend konvexen Formkörpers.

2. **Verfahren zur Herstellung** eines photonischen Kristalls, ausgehend von einem überwiegend konvexen Formkörper, umfassend die Schritte

   (A) Penetration eines Matrixprecursors in die Hohlräume des konvexen Formkörpers;
   (B) Umwandlung des Matrixprecursors zum Matrixbildner;
   (C) Umverteilung des in den Hohlräumen befindlichen Matrixprecursors/ Matrixbildners und/ oder deren Zwischenstufen unter Erhalt der Topologie;
   (D) Entfernen des Formkörpers.

3. Verfahren nach Anspruch 2, wobei die Schritte (C) und (D) simultan erfolgen können.

4. Verfahren nach Anspruch 2 oder 3, wobei der eingebrachte Matrixbildner die Hohlräume des Formkörpers nicht vollständig ausfüllt.

5. Verfahren nach irgendeinem der Ansprüche 2 bis 4, wobei die Entfernung des Formkörpers (C) durch kalzinieren, ätzen oder auflösen erfolgt.

6. Verfahren nach irgendeinem der Ansprüche 2 bis 5, wobei die topologieerhaltenden Umverteilung (B) durch Schrumpfung während der Kalzinierung, Trocknung und/oder Kondensation des Matrixprecursors erfolgt.

7. Verfahren nach irgendeinem der Ansprüche 2 bis 6, wobei die Kalzinierung bei Temperaturen von 450 bis 700 °C innerhalb eines Zeitintervalls von 2 bis 12 h erfolgt.

8. Verfahren nach irgendeinem der Ansprüche 2 bis 7, wobei der Matrixprecursor wenigstens eine Verbindung umfasst, die ausgewählt ist aus der Gruppe, bestehend aus

(i) Metallalkoxiden der allgemeinen Formel $M^{n+}(^-OR)_n$, wobei R eine verzweigte oder unverzweigte Kohlenwasserstoffgruppe mit 1 bis 12 Kohlenstoffatomen ist und M ein Metall ist, welches ausgewählt ist aus den Gruppen IIb, IIIa, IIIb, IVa, IVb und VIIIb des Periodensystems der Elemente.

(ii) Metallhalogeniden und Nitraten der allgemeinen Formel $M^{n+}(X^-)_n$, wobei X ein Halogenid-Ion, ausgewählt aus $F^-$, $Cl^-$, $Br^-$ und $I^-$ oder ein Nitrat-Ion ($NO_3^-$) ist und M ein Metall ist, welches ausgewählt ist aus den Gruppen IIb, IIIa, IIIb, IVa, IVb und VIIIb des Periodensystems der Elemente.

9. Verfahren nach Anspruch 8, wobei der Matrixprecursor wenigstens eine Verbindung umfasst, welches ausgewählt ist aus der Gruppe, bestehend aus Titanisopropoxid, Aluminiumchlorid, Aluminiumnitrat, Eisen(III)chlorid und Eisen(III)nitrat.

10. Verfahren nach irgendeinem der Ansprüche 2 bis 9, wobei dem Matrixprecursor wenigstens ein Lösungsmittel zugesetzt wird, welches ausgewählt ist aus der Gruppe, bestehend aus Methanol, Ethanol, 1-oder 2-Propanol und 1-, 2- oder tert-Butanol.

11. Verfahren nach irgendeinem der Ansprüche 2 bis 10, wobei der Formkörper eine Opalstruktur aufweist.

12. Verfahren nach irgendeinem der Ansprüche 2 bis 11, wobei der Formkörper aus Polymeren oder anorganischen Oxiden besteht, die ausgewählt sind aus der Gruppe bestehend aus Polystyrol, Polymethylmethacrylat (PMMA), Polydivinylbenzol, Poly(styrol-co-divinylbenzol), Melaminharze und Siliziumdioxid.

13. **Photonischer Kristall, erhältlich durch** ein Verfahren gemäß irgendeinem der Ansprüche 2 bis 12, **dadurch gekennzeichnet, dass** dieser

- eine vorwiegend konvexe Struktur besitzt und
- eine Bandlücke oder Pseudobandlücke zwischen dem 5. und 6. Band und/oder
- eine Bandlücke oder Pseudobandlücke zwischen dem 8. und 9. Band aufweist.

14. Photonischer Kristall nach irgendeinem der Ansprüche 1 oder 13, **dadurch gekennzeichnet, dass** dieser gleichzeitig mehrere Bandlücken aufweist.

15. Photonischer Kristall nach irgendeinem der Ansprüche 1 oder 13 bis 14, umfassend zylinderartige Teilstücke, die miteinander verknüpft sind.

16. **Verwendung** eines photonischen Kristalls gemäß irgendeinem der Ansprüche 1 oder 13 bis 15 als Laserresonator, Matrix für Lichtwellenleiter, opaleszentes Pigment, Strahlenteiler oder spektralen Filter oder als Bestanteil der zuvor genannten Vorrichtungen.

## Claims

1. **Photonic crystal,** whose structure is topologically equivalent to the inverse structure of a predominantly convex moulding, **characterized in that** this crystal

- has a predominantly convex structure, and
- has a bandgap or pseudo bandgap between the fifth and sixth bands, and/or
- has a bandgap or pseudo bandgap between the eighth and ninth bands,

with at least one bandgap or pseudo bandgap being greater than that of the inverse structure, which is composed of the same material as the photonic crystal, of the predominantly convex moulding.

2. **Method for production** of a photonic crystal, starting on a predominantly convex moulding, comprising the following steps:

(A) penetration of a matrix precursor into the cavities in the convex moulding;
(B) conversion of the matrix precursor to the matrix former;
(C) redistribution of the matrix precursor/matrix former which is located in the cavities and/or of their intermediate stages while maintaining the topology;
(D) removal of the moulding.

3. Method according to Claim 2, wherein steps (C) and (D) can be carried out simultaneously.

4. Method according to Claim 2 or 3, wherein the matrix former which is introduced does not completely fill the cavities in the moulding.

5. Method according to any of Claims 2 to 4, wherein the moulding (C) is removed by calcination, etching or dissolving.

6. Method according to any of Claims 2 to 5, wherein the redistribution (B) which maintains the topology is carried out by shrinking during the calcination, drying and/or condensation of the matrix precursor.

7. Method according to any of Claims 2 to 6, wherein the calcination is carried out at temperatures from 450 to 700°C within a time interval of 2 to 12 h.

**8.** Method according to any of Claims 2 to 7, wherein the matrix precursor comprises at least one compound which is chosen from the group comprising:

(i) Metal alkoxides with the general formula $M^{n+}$ ($^-$OR)$_n$, where R is a branched or unbranched hydrocarbon group with 1 to 12 carbon atoms and M is a metal which is chosen from the groups IIb, IIIa, IIIb, IVa, IVb and VIIIb in the periodic table of the elements,

(ii) Metal halides and nitrates with the general formula $M^{n+}(X^-)_n$, where X is a halide ion chosen from $F^-$, $Cl^-$, $Br^-$ and $I^-$ or a nitrate ion ($NO_3^-$), and M is a metal which is chosen from the groups IIb, IIIa, IIIb, IVa, IVb and VIIIb in the periodic table of the elements.

**9.** Method according to Claim 8, wherein the matrix precursor comprises at least one compound which is chosen from the group comprising titanium isopropoxide, aluminium chloride, aluminium nitrate, iron (III) chloride and iron(III) nitrate.

**10.** Method according to any of Claims 2 to 9, wherein the matrix precursor has added to it at least one solvent which is chosen from the group comprising methanol, ethanol, 1-propanol or 2-propanol and 1-, 2- or tert-butanol.

**11.** Method according to any of Claims 2 to 10, with the moulding having an opal structure.

**12.** Method according to any of Claims 2 to 11, with the moulding being composed of polymers or inorganic oxides which are chosen from the group comprising polystyrene, polymethylmethacrylate (PMMA), polydivinylbenzene, poly(styrene-co-divinylbenzene), melamine resins and silicon dioxide.

**13.** Photonic crystal, which can be obtained by a method according to any of Claims 2 to 12, **characterized in that** this crystal

- has a predominantly convex structure, and
- has a bandgap or pseudo bandgap between the fifth and sixth bands, and/or
- has a bandgap or pseudo bandgap between the eighth and ninth bands.

**14.** Photonic crystal according to either of claims 1 and 13, **characterized in that** this crystal has two or more bandgaps at the same time.

**15.** Photonic crystal according to any of Claims 1, 13 and 14, comprising cylindrical piece elements, which are linked to one another.

**16. Use** of a photonic crystal according to any of Claims 1 and 13 to 15 as a laser resonator, a matrix for optical waveguides, an opalescent pigment, a beam splitter or a spectral filter, or as a component of the apparatuses mentioned above.

**Revendications**

**1.** Cristal photonique dont la structure est topologiquement équivalente à la structure inverse d'un corps façonné principalement convexe, **caractérisé en ce que** ce dernier :

a une structure principalement convexe,
a un écart énergétique ou un pseudo-écart énergétique entre la 5ème et la 6ème bande et/ou
a un écart énergétique ou un pseudo-écart énergétique entre la 8ème et la 9ème bande,

au moins un écart énergétique étant plus grand que celui de la structure inverse du corps façonné principalement convexe qui est constitué du même matériau que le cristal photonique.

**2.** Procédé de fabrication d'un cristal photonique à partir d'un corps façonné principalement convexe, qui comprend les étapes qui consistent à :

(A) faire pénétrer un précurseur de matrice dans les espaces creux du corps façonné convexe,
(B) convertir le précurseur de matrice en le formateur de matrice,
(C) diviser le précurseur de matrice/formateur de matrice présent dans les espaces creux et/ou leurs étapes intermédiaires tout en respectant la topologie et
(D) enlever le corps façonné.

**3.** Procédé selon la revendication 2, dans lequel les étapes (C) et (D) peuvent être réalisées simultanément.

**4.** Procédé selon les revendications 2 ou 3, dans lequel le formateur de matrice inséré ne remplit pas complètement les espaces creux du corps façonné.

**5.** Procédé selon l'une quelconque des revendications 2 à 4, dans lequel l'enlèvement du corps façonné (C) s'effectue par calcination, gravure ou dissolution.

**6.** Procédé selon l'une quelconque des revendications 2 à 5, dans lequel la conversion (B) s'effectue par retrait pendant la calcination, le séchage et/ou la condensation du précurseur de matrice.

**7.** Procédé selon l'une quelconque des revendications 2 à 6, dans lequel la calcination a lieu à des températures comprises entre 450 et 700°C pendant une durée de 2 à 12 h.

8. Procédé selon l'une quelconque des revendications 2 à 7, dans lequel le précurseur de matrice comporte au moins un composé sélectionné dans l'ensemble constitué des :

(i) alcoxydes de métaux de formule générale $M^{n+}(-OR)_n$, dans laquelle R représente un groupe hydrocarbure ramifié ou non ramifié qui compte de 1 à 12 atomes de carbone et M est un métal sélectionné parmi les groupes IIB, IIIa, IIIb, IVa, IVb et VIIIb du système périodique des éléments,
(ii) des halogénures et des nitrates de métaux de formule générale $M^{n+}(X^-)_n$, dans laquelle X représente un ion halogénure sélectionné parmi $F^-$, $Cl^-$, $Br^-$ et $I^-$ ou un ion nitrate ($NO_3^-$) et M représente un métal sélectionné parmi les groupes IIB, IIIa, IIIb, IVa, IVb et VIIIb du système périodique des éléments.

9. Procédé selon la revendication 8, dans lequel le précurseur de matrice contient au moins un composé sélectionné dans l'ensemble constitué de l'isopropoxyde de titane, du chlorure d'aluminium, du nitrate d'aluminium, du chlorure de fer (III) et du nitrate de fer (III).

10. Procédé selon l'une quelconque des revendications 2 à 9, dans lequel le précurseur de matrice est exposé à au moins un solvant sélectionné dans l'ensemble constitué du méthanol, de l'éthanol, du 1- ou du 2-propanol et du 1-, 2- ou du tert.-butanol.

11. Procédé selon l'une quelconque des revendications 2 à 10, dans lequel le corps façonné présente une structure opaline.

12. Procédé selon l'une quelconque des revendications 2 à 11, dans lequel le corps façonné est constitué de polymères ou d'oxydes minéraux sélectionnés dans l'ensemble constitué du polystyrène, du poly (méthacrylate de méthyle) (PMMA), du polydivinylbenzène, du poly(styrène-co-divinylbenzène), des résines de mélamine et du dioxyde de silicium.

13. Cristal photonique obtenu à l'aide d'un procédé selon l'une quelconque des revendications 2 à 12 et **caractérisé en ce que** le cristal photonique :

a une structure principalement convexe,
a un écart énergétique ou un pseudo-écart énergétique entre la 5ème et la 6ème bande et/ou
a un écart énergétique ou un pseudo-écart énergétique entre la 8ème et la 9ème bande.

14. Cristal photonique selon l'une quelconque des revendications 1 ou 3, **caractérisé en ce qu'**il présente simultanément plusieurs écarts énergétiques.

15. Cristal photonique selon l'une quelconque des revendications 1 ou 13 à 14, qui comprend des pièces partielles cylindriques reliées les unes aux autres.

16. Utilisation d'un cristal photonique selon l'une quelconque des revendications 1 ou 13 à 15 comme résonateur laser, matrice pour guide d'ondes lumineuses, pigment opalescent, diviseur de faisceaux, filtre spectral ou comme composant des dispositifs mentionnés ci-dessus.

Fig. 1

Fig. 2